(19) Europäisches Patentamt
European Patent Office
Office européen des brevets

(11) EP 2 693 459 A1

(12) # EUROPEAN PATENT APPLICATION
published in accordance with Art. 153(4) EPC

(43) Date of publication:
**05.02.2014 Bulletin 2014/06**

(21) Application number: **12763096.0**

(22) Date of filing: **28.03.2012**

(51) Int Cl.:
***H01L 21/304*** *(2006.01)* ***B24B 37/00*** *(2012.01)*
***C09K 3/14*** *(2006.01)*

(86) International application number:
**PCT/JP2012/058195**

(87) International publication number:
**WO 2012/133561 (04.10.2012 Gazette 2012/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.03.2011 JP 2011076475**
**31.05.2011 JP 2011122438**

(71) Applicant: **Fujimi Incorporated**
**Kiyosu-shi, Aichi 452-8502 (JP)**

(72) Inventors:
- **TAMADA, Shuichi**
  **Kiyosu-shi**
  **Aichi 452-8502 (JP)**
- **HIRANO, Tatsuhiko**
  **Kiyosu-shi**
  **Aichi 452-8502 (JP)**
- **IZAWA, Yoshihiro**
  **Kiyosu-shi**
  **Aichi 452-8502 (JP)**
- **ONISHI, Shogo**
  **Kiyosu-shi**
  **Aichi 452-8502 (JP)**

(74) Representative: **Grünecker, Kinkeldey,**
**Stockmair & Schwanhäusser**
**Leopoldstrasse 4**
**80802 München (DE)**

(54) **POLISHING COMPOSITION AND POLISHING METHOD**

(57) Disclosed is a polishing composition containing a substance that lowers the pH of an aqueous solution in the presence of an oxidizing agent, and a pH-buffering agent. The difference in absolute value between the pH of the polishing composition immediately after adding a 31 % by weight hydrogen peroxide solution thereto at 5.16 g per 100 g of the polishing composition and the pH of the polishing composition after leaving to stand for eight days from the addition of hydrogen peroxide is 0.5 or less. Also disclosed is another polishing composition containing a substance that lowers the pH of an aqueous solution in the presence of an oxidizing agent, and a pH-controlling agent. In comparison to the amount of a basic substance in the polishing composition immediately after adding a 31% by weight hydrogen peroxide solution thereto at 5.16 g per 100 ml of the polishing composition, the amount of a basic substance in the polishing composition after leaving to stand for eight days from the addition of hydrogen peroxide is increased by no less than 0.1 mM.

EP 2 693 459 A1

## Description

### TECHNICAL FIELD

The present invention relates to a polishing composition used, for example, in polishing a metal-containing substrate surface (hereinafter referred to as "object to be polished") in a large-scale integration (hereinafter referred to as "LSI").

### BACKGROUND ART

New microfabrication techniques are being developed with the realization of higher integration degrees and higher operational speeds of LSIs. A chemical mechanical polishing (hereinafter referred to as "CMP") method is one such technique that is applied to planarization of interlayer insulating films, formation of contact plugs, and formation of embedded wiring in LSI manufacturing processes, particularly in multilayer wiring forming processes. This technique is disclosed, for example, in Patent Document 1.

In forming contact plugs, tungsten is used as an embedding material and as a material of an interdiffusion barrier for the contact plugs. A method where excess portions, other than contact plugs, are removed by CMP is used for forming the contact plugs. In forming embedded wiring, to make an LSI high in performance, copper or a copper alloy is recently being used as a conductive substance that is to be a wiring material. With copper or a copper alloy, it is difficult to perform microfabrication by a dry etching method that is frequently used in forming conventional aluminum alloy wiring, and therefore a so-called damascene method, with which a thin film of copper or a copper alloy is deposited on and embedded in an insulating film having a groove formed in advance and the thin film is thereafter removed by CMP at portions other than in the groove to form embedded wiring, is mainly used. Generally in a metal polishing composition used in CAMP, an acid or other polishing accelerator and an oxidizing agent are contained and abrasive grains are further contained as necessary. In order to improve flatness of a polished object, it is also considered effective to use a polishing composition to which a metal anticorrosive is further added. For example, use of a polishing composition containing either or both of aminoacetic acid and amidosulfuric acid, an oxidizing agent, benzotriazole, and water is disclosed in Patent Document 2.

However, when an oxidizing agent is added to a polishing composition, there is a problem that the polishing performance changes with time. Although various factors responsible for the change of polishing performance have been confirmed, one of the factors is a change in the pH of the polishing composition due to interaction of chemical substances in the polishing composition, such as a polishing accelerator and a metal anticorrosive, with the oxidizing agent.

The pH is very important in designing a metal polishing composition and generally, the pH of a polishing composition is set based on a Pourbaix diagram. For example, Patent Document 3 discloses that it is important for a copper polishing composition to have a pH of approximately 6.0 in order to form copper(I) oxide. When the pH of the polishing composition decreases, it is difficult for copper oxide to form on a copper surface and dissolution of metallic copper increases. Also, when the pH of the polishing composition increases, copper in the solution may precipitate, adhere to the wafer surface, and thereby cause formation of scratches. Therefore, in order to obtain a flat surface without defects after CMP, it is required that the pH of a metal polishing composition be constantly stable.

Although Patent Document 4 discloses a technique of stabilizing the pH of a polishing composition during a copper polishing process that lasts for a few minutes, there is no specific disclosure of suppressing the change with time of the pH over a longer period and the technique is technically difficult as well.

### PRIOR ART DOCUMENTS

Patent Document 1: Japanese Laid-Open Patent Publication No. 62-102543
Patent Document 2: Japanese Laid-Open Patent Publication No. 8-83780
Patent Document 3: Japanese National Phase Laid-Open Patent Publication No. 2000-501771
Patent Document 4: Japanese National Phase Laid-Open Patent Publication No. 2006-506809


### SUMMARY OF THE INVENTION

#### Problems that the Invention is to Solve

An of the present invention is to provide a polishing composition that is used in manufacturing LSIs and that is

capable of suppressing the change of pH with time after addition of an oxidizing agent thereto, a polishing method using the polishing composition, and a method of producing a substrate by the polishing method.

Means for Solving the Problems

The present inventors have conducted diligent studies and found out a polishing composition having stable characteristics not only during polishing but also over a long period from the point of addition of an oxidizing agent for the purpose of use in polishing until the polishing composition is used up.

That is, a first aspect of the present invention provides a polishing composition containing a substance that lowers the pH of an aqueous solution in the presence of an oxidizing agent, and a pH-buffering agent. The polishing composition is characterized in that the difference in absolute value between the pH immediately after adding a 31 % by weight hydrogen peroxide solution thereto at 5.16 g, that is, adding hydrogen peroxide thereto at 1.6 g per 100 g of the polishing composition and the pH after leaving to stand for eight days from the addition of the hydrogen peroxide solution is 0.5 or less.

A second aspect of the present invention provides a polishing composition containing a substance that lowers the pH of an aqueous solution in the presence of an oxidizing agent, and a pH-controlling agent. The polishing composition is characterized in that in comparison to the amount of a basic substance in the polishing composition immediately after adding a 31% by weight hydrogen peroxide solution thereto at 5.16 g per 100 ml of the polishing composition, the amount of a basic substance in the polishing composition after leaving to stand for eight days from the addition of the hydrogen peroxide solution is increased by no less than 0.1 mM.

A third aspect of the present invention provides a method of polishing a metal with the polishing composition according to the first or second aspect. A fourth aspect of the present invention provides a method of producing a metal-containing substrate, the method including polishing a metal by the method according to the third aspect.

Effects of the Invention

According to the present invention, a polishing composition that is used in manufacturing LSIs and is low in change of pH with time, a polishing method using the polishing composition, and a method of producing a substrate by the polishing method are provided.

MODE FOR CARRYING OUT THE INVENTION

A first embodiment of the present invention will now be described below.

A polishing composition of the present embodiment contains a substance that lowers the pH of an aqueous solution in the presence of an oxidizing agent, and a pH-buffering agent and optionally further contains abrasive grains and another additive. The polishing composition is prepared by mixing these components in a solvent, such as water.

The polishing composition of the present embodiment is mainly used in polishing for manufacturing an LSI such as described in the "BACKGROUND ART" section, particularly in a metal polishing process. More specifically, the polishing composition is used in polishing for forming metal wiring, contact holes, and via holes in an LSI. Examples of the metal polished with the polishing composition include copper, tungsten, tantalum, titanium, cobalt, ruthenium, and oxides, alloys, and compounds thereof. Among these, copper, tantalum, titanium, ruthenium, and oxides, alloys, and compounds thereof are preferable, and copper and oxides, alloys, and compounds thereof are more preferable.

(Oxidizing agent)

The oxidizing agent has an action of oxidizing the surface of an object to be polished and the addition of an oxidizing agent to the polishing composition provides an advantage that the rate of polishing with the polishing composition is improved.

The oxidizing agent that may be used is, for example, a peroxide. Examples of a peroxide include hydrogen peroxide, peracetic acid, percarbonates, urea peroxide, perchloric acid, and persulfates, such as sodium persulfate, potassium persulfate, and ammonium persulfate. Among these, persulfates and hydrogen peroxide are preferable from the standpoint of the polishing rate and hydrogen peroxide is especially preferable from the standpoints of the stability in an aqueous solution and a reduction in the environmental impact.

The content of the oxidizing agent in the polishing composition is preferably no less than 0.1 g/L, more preferably no less than 1 g/L, and even more preferably no less than 3 g/L. As the oxidizing agent content increases, the rate of polishing with the polishing composition is advantageously improved.

The content of the oxidizing agent in the polishing composition is preferably 200 g/L or less, more preferably 100g/L or less, and even more preferably 40 g/L or less. A decrease in the oxidizing agent content is advantageous in

that the material cost of the polishing composition is reduced and additionally, in that the burden of treating the polishing composition after use in polishing, that is, the burden of waste liquid treatment is reduced. Further, there is an advantage that excessive oxidation of the surface of an object to be polished by the oxidizing agent is made less likely to occur.

(pH-lowering substance)

The pH-lowering substance that lowers the pH of an aqueous solution in the presence of an oxidizing agent is a substance among surfactants, water-soluble polymers, amine compounds, metal anticorrosives, and organic solvents that satisfies the following condition. That is, an aqueous solution containing 0.05% by weight of a surfactant or a water-soluble polymer or 5 mmol/L of an amine compound, a metal anticorrosive, or an organic solvent is prepared, and the pH of the aqueous solution is adjusted to approximately 7.5 by adding potassium hydroxide or sulfuric acid as a pH adjusting agent. Then, the pH of the aqueous solution immediately after adding a 31% by weight hydrogen peroxide solution thereto at 10.32 g per 100 g of the aqueous solution, that is, adding hydrogen peroxide thereto at 3.2 g per 100 g of the aqueous solution, and the pH of the aqueous solution after leaving to stand for eight days under ordinary temperature (23°C to 27°C) from the addition of hydrogen peroxide are compared. The condition is that the difference in absolute value between these pH values is no less than 0.5.
Examples of a surfactant satisfying the condition for the ph-lowering substance include a nonionic surfactant having a polyoxyalkylene group. Examples of the nonionic surfactant include polyoxyethylene alkyl ether.
Examples of a water-soluble polymer satisfying the condition for the pH-lowering substance include a water-soluble polymer having a nitrogen atom in its structure. Examples of a water-soluble polymer having a nitrogen atom in its structure include a reaction condensate of at least one raw material monomer and a second raw material monomer, the at least one raw material monomer being selected from among bases having two or more amino groups, for example, diethylenetriamine, triethylenetetramine, tetraethylenepentamine, iminobispropylamine, dimethylaminoethylamine, dimethylaminopropylamine, diethylaminoethylamine, diethylaminopropylamine, dibutylaminopropylamine, ethylaminoethylamine, 1,2-diaminopropane, 1,3-diaminopropane, 1,4-diaminobutane, methylaminopropylamine, diethylenetriamine, triethylenetetramine, tetraethylenepentamine, pentaethylenehexamine, dipropylenetriamine, tripropylenetetramine, 2-hydroxyaminopropylamine, methylbis-(3-aminopropyl)amine, dimethylaminoethoxypropylamine, 1,2-bis-(3-aminopropoxy)-ethane, 1,3-bis-(3-aminopropoxy)-2,2-dimethylpropane, $\alpha,\omega$-bis-(3-aminopropoxy)-polyethylene glycol ether, iminobispropylamine, methyliminobispropylamine, laurylaminopropylamine, diethanolaminopropylamine, N-aminoethylpiperidine, N-aminoethylpipecoline, N-aminoethylmorpholine, N-aminopropylpiperidine, N-aminopropyl-2-pipecoline, N-aminopropyl-4-pipecoline, N-aminopropyl-4-morpholine, and N-aminopropylmorpholine, and the second raw material monomer being composed of at least one polybasic acid selected, for example, from among oxalic acid, malonic acid, succinic acid, glutaric acid, adipic acid, and pimelic acid. Another example of a water-soluble polymer having a nitrogen atom in its structure is a product of reacting at least one substance selected, for example, from among urea and epihalohydrins with the reaction condensate of the first raw material monomer and the second raw material monomer,
**[0024]** Examples of an amine compound satisfying the condition for the ph-lowering substance include a compound having an amino group. Examples of a compound having an amino group include ethylenediaminetetraacetic acid (EDTA), N-methylethylenediamine, N,N,N,N-tetrakis(2-hydroxypropyl)ethylenediamine, 1,4-diazabicyclo[2,2,2]octane, and N,N-di-tert-butylethane-1,2-diamine.
Examples of a metal anticorrosive satisfying the condition for the ph-lowering substance include 1H-benzotriazole, 5-methyl-1H-benzotriazole, 1-[N,N-bis(hydroxyethyl)aminomethyl]-4-methylbenzotriazole, 1-[N,N-bis(hydroxyethyl)aminomethyl]-5-methylbenzotriazole, 3-mercapto-1,2,4-triazole, 3-amino-5-mercapto-1,2,4-triazole, 3-mercaptomethyl-4H-1,2,4-triazole, benzoylhydrazine, salicylhydrazide, 4-hydroxybenzohydrazide, dihydrazide isophthalate, dihydrazide terephthalate, benzohydroxamic acid, salicylhydroxamic acid, 1H-benzotriazole-1-methanol, and 2,2-biphenol.
Examples of an organic solvent satisfying the condition for the ph-lowering substance include a compound having an alcoholic hydroxyl group. Examples of a compound having an alcoholic hydroxyl group include methanol, ethanol, propanol, ethylene glycol, and polyethylene glycol.
With regard to aqueous solutions containing any of the substances described above as examples of the ph-lowering substance, the changes in pH with time were examined in the presence of and in the absence of hydrogen peroxide and the results are shown in Table 1. Specifically, each aqueous solution containing a predetermined amount of a ph-lowering substance was adjusted to a pH of approximately 7.5 by addition of potassium hydroxide or sulfuric acid and thereafter left to stand in storage for eight days under ordinary temperature (23°C to 27°C) using a constant temperature bath. The pH value of each aqueous solution measured immediately after the pH adjustment, the pH value of each aqueous solution measured after being left to stand for the eight days, and the amount of pH change that occurred within the eight days are respectively indicated in the "pH immediately after preparation" column, the "pH after eight days" column, and the "pH change amount" column in the "Without hydrogen peroxide" column. Also, a 31% by weight

hydrogen peroxide solution was added to each aqueous solution immediately after the pH adjustment to approximately 7.5 at 10.32 g per 100 g of the aqueous solution (that is, hydrogen peroxide was added at 3.2 g per 100 g of the aqueous solution) and thereafter each aqueous solution was left to stand in storage for eight days under ordinary temperature (23°C to 27°C) using a constant temperature bath. The pH value of each aqueous solution measured immediately after the addition of hydrogen peroxide, the pH value of each aqueous solution measured after being left to stand for the eight days, and the amount of pH change that occurred within the eight days are respectively indicated in the "pH immediately after preparation" column, the "pH after eight days" column, and the "pH change amount" column in the "With hydrogen peroxide" column. The pH of each aqueous solution was measured under ordinary temperature (23°C to 27°C) using a pH meter (F-52, from Horiba, Ltd.).

Table 1

| | pH-lowering substance | | With hydrogen peroxide | | | Without hydrogen peroxide | | |
|---|---|---|---|---|---|---|---|---|
| | Name | Content | pH immediately after preparation | pH after eight days | pH change amount | pH immediately after preparation | pH after eight days | pH change amount |
| Example 1 | none | - | 7.44 | 7.43 | -0.01 | 7.48 | 7.47 | -0.01 |
| Example 2 | 1-[N,N-bis(hydroxyethyl)aminomethyl] -5-methylbenzotriazole | 5 mmol/L | 7.50 | 5.24 | -2.26 | 7.47 | 7.46 | -0.01 |
| Example 3 | 1-[N,N-bis(hydroxyethyl)aminomethyl] -4-methylbenzotriazole | 5 mmol/L | 7.50 | 5.24 | -2.26 | 7.47 | 7.46 | -0.01 |
| Example 4 | 1H-benzotriazole | 5 mmol/L | 7.46 | 4.78 | -2.68 | 7.46 | 7.40 | -0.06 |
| Example 5 | 5-methyl-1H-benzotriazole | 5 mmol/L | 7.45 | 4.80 | -2.65 | 7.45 | 6.32 | -1.13 |
| Example 6 | trimethylamine | 5 mmol/L | 7.58 | 5.75 | -1.83 | 7.55 | 7.48 | -0.07 |
| Example 7 | 2,2-methyliminodiethanol | 5 mmol/L | 7.45 | 5.21 | -2.24 | 7.46 | 7.40 | -0.06 |
| Example 8 | diethylenetriamine-adipic acid condensate | 0.05 wt.% | 7.53 | 6.42 | -1.11 | 7.55 | 7.44 | -0.11 |
| Example 9 | diethylenetriamine-succinic acid condensate | 0.05 wt.% | 7.55 | 5.74 | -1.81 | 7.55 | 7.44 | -0.11 |
| Example 10 | Polyoxyethylene lauryl ether | 0.05 wt.% | 7.44 | 6.70 | -0.74 | 7.55 | 7.44 | -0.11 |
| Example 11 | Ethanol | 5 mmol/L | 7.42 | 6.72 | -0.70 | 7.55 | 7.51 | -0.04 |

(pH-buffering agent)

The pH-buffering agent is blended in the polishing composition so that the difference in absolute value between the pH of the polishing composition immediately after adding a 31% by weight hydrogen peroxide solution thereto at 5.16 g per 100 g of the polishing composition, that is, adding hydrogen peroxide thereto at 1.6 g per 100 g of the polishing composition and the pH of the polishing composition after leaving to stand for eight days after from the addition of the hydrogen peroxide solution is 0.5 or less. If the difference in absolute value between these pH values is 0.5 or less, the lowering of polishing performance with time of the polishing composition can be suppressed to a level that does not present a problem in terms of practical use and a polishing composition of excellent stability can be provided.

The pH-buffering agent is preferably a compound having an amide group and is more preferably an amphoteric amino acid further having at least one of a sulfo group and a carboxyl group in addition to the amide group. The pH-buffering agent may be a compound represented by the following general formula (1).

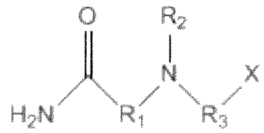

... (1)

In the general formula (1), $R_1$ and $R_3$ each independently represent a non-substituted or substituted straight-chain alkyl group with 1 to 4 carbon atoms. $R_2$ represents a hydrogen atom, a hydroxyl group, a sulfo group, a carboxyl group, an amino group, an amide group, a carbamoyl group, a nitro group, a methoxy group, an ethoxy group, a halogen group, a phenyl group, an acetyl group, or a non-substituted or substituted alkyl group with 1 to 4 carbon atoms. X represents a sulfo group, a carboxyl group, or a salt thereof.

Preferable compounds represented by the general formula (1) are N-(2-acetamido)iminodiacetic acid and N-(2-acetamido)-2-aminoethanesulfonic acid, and N-(2-acetamido)-2-aminoethanesulfonic acid is most preferable.

The mechanism by which the change of pH with time of the polishing composition is suppressed by the addition of the pH-buffering agent has not been clarified. However, when the pH-buffering agent has a sulfo group or carboxyl group with a low acid dissociation constant, an acid dissociation equilibrium reaction is expected with a proton that is newly formed in the presence of the oxidizing agent and the ph-lowering substance. Also, it is considered that, when the pH-buffering agent is a compound having an amide group, the ammonia that forms as a result of hydrolysis by the oxidizing agent neutralizes the proton mentioned above.

The content of the pH-buffering agent in the polishing composition is preferably no less than 0.01 mmol/L, more preferably no less than 0.1 mmol/L, even more preferably no less than 0.5 mmol/L, yet even more preferably no less than 3.0 mmol/L, and most preferably no less than 5.0 mmol/L, An increase in the pH-buffering agent content is desirable in that an effect of stabilizing the pH of the polishing composition is improved.

The content of the pH-buffering agent in the polishing composition is preferably 300 mmol/L or less, more preferably 150 mmol/L or less, even more preferably 100 mmol/L or less, and especially preferably 50 mmol/L or less.A decrease in the pH-buffering agent content is advantageous in that the material cost of the polishing composition is reduced. In particular, when the content is 50 mmol/L or less, a high polishing rate can be maintained in addition to providing the effect of suppressing the change of pH with time of the polishing composition.

(pH of the polishing composition)

The pH of the polishing composition is preferably no less than 3, more preferably no less than 5, and even more preferably no less than 6. As the pH increases, there is an advantage that excessive etching of the surface of an object to be polished by the polishing composition is made less likely to occur.

The pH of the polishing composition is preferably 9 or less and more preferably 8 or less. As the pH decreases, there is an advantage that scratching of the surface of an object to be polished by the polishing composition can be suppressed.

(Polishing accelerator)

In addition to the oxidizing agent, the ph-lowering substance, and the pH-buffering agent, the polishing composition may further contain a polishing accelerator that is not classified under the above. The polishing accelerator provides an action of chemically etching the surface of an object to be polished and functions to improve the rate of polishing with the polishing composition.

Examples of polishing accelerators that may be used include inorganic acids, organic acids, and amino acids other than those given above as examples of the pH-lowering substance and the pH-buffering agent.

Examples of an inorganic acid include sulfuric acid, nitric acid, boric acid, carbonic acid, hypophosphorous acid, phosphorous acid, and phosphoric acid.

Examples of an organic acid include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid. An organic sulfuric acid, such as methanesulfonic acid, ethanesulfonic acid, and isethionic acid, may also be used.

A salt, such as an ammonium salt and an alkali metal salt, of an inorganic acid or an organic acid may be used, either instead of an inorganic acid or organic acid or in combination with an inorganic acid or organic acid. In cases where a weak acid is used in combination with a strong base, a strong acid is used in combination with a weak base, or a weak acid is used in combination with a weak base, a pH-buffering action is expected.

Examples of an amino acid include glycine, α-alanine, β-alanine, N-methylglycine, N,N-dimethylglycine, 2-aminobutyric acid, norvaline, valine, leucine, norleucine, isoleucine, phenylalanine, proline, sarcosine, ornithine, lysine, taurine, serine, threonine, homoserine, tyrosine, bicine, tricine, 3,5-diiodo-tyrosine, β-(3,4-dihydroxyphenyl)-alanine, thyroxine, 4-hydroxy-proline, cysteine, methionine, ethionine, lanthionine, cystathionine, cystine, cysteic acid, aspartic acid, glutamic acid, S-(carboxymethyl)-cysteine, 4-aminobutyric acid, asparagine, glutamine, azaserine, arginine, canavanine, citrulline, δ-hydroxy-lysine, creatine, histidine, 1-methyl-histidine, 3-methyl-histidine, and tryptophan.

Among these, a polishing accelerator that is preferable from the standpoint of a polishing rate improvement is glycine, alanine, malic acid, tartaric acid, citric acid, glycolic acid, isethionic acid, or an ammonium salt or alkali metal salt thereof.

The content of the polishing accelerator in the polishing composition is preferably no less than 0.01 g/L, more preferably no less than 0.1 g/L, and even more preferably no less than 1 g/L. As the polishing accelerator content increases, the rate of polishing with the polishing composition is advantageously improved.

The content of the polishing accelerator in the polishing composition is preferably 50 g/L or less, more preferably 30 g/L or less, and even more preferably 15 g/L or less. As the polishing accelerator content decreases, there is an advantage that excessive etching of the surface of an object to be polished by the oxidizing agent is made less likely to occur.

(Surfactant)

In addition to the oxidizing agent, the ph-lowering substance, and the pH-buffering agent, the polishing composition may further contain a surfactant that is not classified under the above. When the surfactant is added to the polishing composition, in addition to recesses becoming unlikely to form at sides of a wiring formed by polishing with the polishing composition, there is an advantage that dishing becomes unlikely to occur on the surface of an object after polishing with the polishing composition.

The surfactant used may be any of an anionic surfactant, cationic surfactant, amphoteric surfactant, and nonionic surfactant. A plurality of types of surfactants may be used in combination and in particular, combined use of an anionic surfactant and a nonionic surfactant is preferable from the standpoint of suppressing recesses at sides of a wiring and dishing.

Examples of an anionic surfactant include polyoxyethylene alkyl sulfuric acid esters, polyoxyethylene alkyl acetic acid esters, polyoxyethylene alkyl phosphoric acid esters, alkyl sulfuric acid esters, polyoxyethylene alkyl sulfuric acids, alkyl sulfuric acids, alkylbenzene sulfonic acids, alkyl phosphoric acid esters, polyoxyethylene alkyl phosphoric acid esters, polyoxyethylene sulfosuccinic acid, alkyl sulfosuccinic acids, alkyl naphthalene sulfonic acids, alkyl ether sulfuric acids, and salts thereof. These anionic surfactants are high in chemical or physical adsorption ability to the surface of an object to be polished and form stronger protective films on the surface of an object to be polished. This is advantageous for improving the flatness of the surface of an object after polishing with the polishing composition.

Examples of a cationic surfactant include alkyltrimethylammonium salts, alkyldimethylammonium salts, alkylbenzyldimethylammonium salts, and alkylamine salts.

Examples of an amphoteric surfactant include alkylbetaines and alkylamine oxides.

Examples of a nonionic surfactant include sorbitan fatty acid esters, glycerin fatty acid esters, polyoxyethylene fatty acid esters, polyoxyethylene alkyl amines, and alkyl alkanol amides. These nonionic surfactants are high in chemical or physical adsorption ability to the surface of an object to be polished and form stronger protective films on the surface of an object to be polished. This is advantageous for improving the flatness of the surface of an object after polishing with the polishing composition.

The content of the surfactant in the polishing composition is preferably no less than 0.001 g/L, more preferably no less than 0.005 g/L, and even more preferably no less than 0.01 g/L. As the surfactant content increases, the flatness of the surface of an object after polishing with the polishing composition is advantageously improved.

the content of the surfactant in the polishing composition is preferably 10 g/L or less, more preferably 5 g/L or less, and even more preferably 1 g/L or less. As the surfactant content decreases, the rate of polishing with the polishing composition is advantageously improved.

(Metal anticorrosive)

In addition to the oxidizing agent, the ph-lowering substance, and the pH-buffering agent, the polishing composition may further contain a metal anticorrosive that is not classified under the above. As in the case where the surfactant is added, when the metal anticorrosive is added to the polishing composition, in addition to recesses becoming unlikely to form at sides of a wiring formed by polishing with the polishing composition, there is an advantage that dishing becomes unlikely to occur on the surface of an object after polishing with the polishing composition. Also, when an oxidizing agent is contained in the polishing composition, the metal anticorrosive has functions of lessening the oxidation

of the surface of an object to be polished by the oxidizing agent and of reacting with metal ions formed by oxidation of a metal at the surface of an object to be polished to form an insoluble complex. These functions of the metal anticorrosive improve flatness of the surface of an object after polishing with the polishing composition.

Although the type of metal anticorrosive used is not restricted in particular, it is preferably a heterocyclic compound. The number of heterocyclic rings in the heterocyclic ring is not restricted in particular. The heterocyclic compound may be a monocyclic compound or a polycyclic compound having a condensed ring.

Examples of heterocyclic compounds useable as the metal anticorrosive include nitrogen-containing heterocyclic compounds, such as pyrrole compounds, pyrazole compounds, imidazole compounds, triazole compounds, tetrazole compounds, pyridine compounds, pyrazine compounds, pyridazine compounds, pyrindine compounds, indolizine compounds, indole compounds, isoindole compounds, indazole compounds, purine compounds, quinolizine compounds, quinoline compounds, isoquinoline compounds, naphthyridine compounds, phthalazine compounds, quinoxaline compounds, quinazoline compounds, cinnoline compounds, buterizine compounds, thiazole compounds, isothiazole compounds, oxazole compounds, isoxazole compounds, and furazan compounds.

Examples of a pyrazole compound include 1H-pyrazole, 4-nitro-3-pyrazole carboxylic acid, and 3,5-pyrazole carboxylic acid.

Examples of an imidazole compound include imidazole, 1-methylimidazole, 2-methylimidazole, 4-methylimidazole, 1,2-dimethylpyrazole, 2-ethyl-4-methylimidazole, 2-isopropylimidazole, benzimidazole, 5,6-dimethylbenzimidazole, 2-aminobenzimidazole, 2-chlorobenzimidazole, and 2-methylbenzimidazole.

Examples of a triazole compound include 1,2,3-triazole, 1,2,4-triazole, 1-methyl-1,2,4-triazole, methyl-1 H-1,2,4-triazole-3-carboxylate, 1,2,4-triazole-3-carboxylic acid, methyl 1,2,4-triazole-3-carboxylate, 3-amino-1H-1,2,4-triazole, 3-amino-5-benzyl-4H-1,2,4-triazole, 3-amino-5-methyl-4H-1,2,4-triazole, 3-nitro-1,2,4-triazole, 3-bromo-5-nitro-1,2,4-triazole, 4-(1,2,4-triazole-1-yl)phenol, 4-amino-1,2,4-triazole, 4-amino-3,5-dipropyl-4H-1,2,4-triazole, 4-amino-3,5-dimethyl-4H-1,2,4-triazole, 4-amino-3,5-dipeptyl-4H-1,2,4-triazole, 5-methyl-1,2,4-triazole-3,4-diamine, 1-hydroxybenzotriazole, 1-aminobenzotriazole, 1-carboxybenzotriazole, 5-chloro-1H-benzotriazole, 5-nitro-1H-benzotriazole, 5-carboxy-1H-benzotriazole, 5,6-dimethyl-1H-benzotriazole, and 1-(1",2'-dicarboxyethyl)benzotriazole.

Examples of a tetrazole compound include 1H-tetrazole, 5-methyltetrazole, 5-aminotetrazole, and 5-phenyltetrazole.

Examples of an indole compound include 1H-indole, 1-methyl-1H-indole, 2-methyl-1H-indole, 3-methyl-1H-indole, 4-methyl-1H-indole, 5-methyl-1H-indole, 6-methyl-1H-indole, and 7-methyl-1H-indole,

Examples of an indazole compound include 1H-indazole and 5-amino-1H-indazole.

Among these, a preferable heterocyclic compound is a compound having a triazole skeleton and 1,2,3-triazole and 1,2,4-triazole are especially preferable. These heterocyclic compounds are high in chemical or physical adsorption ability to the surface of an object to be polished and form stronger protective films on the surface of an object to be polished. This is advantageous for improving the flatness of the surface of an object after polishing with the polishing composition.

The content of the metal anticorrosive in the polishing composition is preferably no less than 0.001 g/L, more preferably no less than 0.005 g/L, and even more preferably no less than 0.01 g/L. As the metal anticorrosive content increases, the flatness of the surface of an object after polishing with the polishing composition is advantageously improved.

The content of the metal anticorrosive in the polishing composition is preferably 10 g/L or less, more preferably 5 g/L or less, and even more preferably 1 g/L or less. As the metal anticorrosive content decreases, the rate of polishing with the polishing composition is advantageously improved.

(Water-soluble polymer)

In addition to the oxidizing agent, the pH-lowering substance, and the pH-buffering agent, the polishing composition may further contain a water-soluble polymer that is not classified under the above. When the water-soluble polymer is added to the polishing composition, in addition to enabling control of the rate of polishing with the polishing composition by adsorption of the water-soluble polymer on the surfaces of abrasive grains or the surface of an object to be polished, there is an advantage of enabling stabilization of insoluble components in the polishing composition that form during polishing.

Examples of a water-soluble polymer that may be used include polysaccharides, such as alginic acid, pectic acid, carboxymethylcellulose, curdlan, and pullulan; polycarboxylic acids and salts thereof; vinyl polymers, such as polyvinyl alcohol and polyacrolein; and polyglycerin and polyglycerin esters. Among these, carboxymethylcellulose, pullulan, polycarboxylic acids and salts thereof, and polyvinyl alcohol are preferable and pullulan and polyvinyl alcohol are especially preferable.

(Abrasive grains)

Abrasive grains have an action of mechanically polishing an object to be polished and the addition of abrasive grains to the polishing composition provides an advantage that the rate of polishing with the polishing composition is improved.

The abrasive grains used may be any of inorganic particles, organic particles, and organic/inorganic composite particles. Examples of inorganic particles include particles made of a metal oxide, such as silica, alumina, ceria, and titania, silicon nitride particles, silicon carbide particles, and boron nitride particles. Among these, silica is preferable and colloidal silica is especially preferable. Examples of organic particles include polymethyl methacrylate (PMMA) particles.

The abrasive grains used have an average primary particle diameter of preferably no less than 5 nm, more preferably no less than 7 nm, and even more preferably no less than 10 nm. As the average primary particle diameter of the abrasive grains increases, the rate of polishing with the polishing composition is advantageously improved.

The abrasive grains used have an average primary particle diameter of preferably 100 nm or less, more preferably 60 nm or less, and even more preferably 40 nm or less. As the average primary particle diameter of the abrasive grains decreases, there is an advantage that dishing becomes unlikely to occur on the surface of an object after polishing with the polishing composition. The value of the average primary particle diameter of the abrasive grains is calculated, for example, by the formula: average primary particle diameter [nm] = constant / specific surface area [$m^2/g$] based on the specific surface area of the abrasive grains measured by the BET method. If the abrasive grains are silica or colloidal silica, the above constant is 2121.

The content of the abrasive grains in the polishing composition is preferably no less than 0.005% by mass, more preferably no less than 0.01 % by mass, and even more preferably no less than 0.05% by mass. As the abrasive grain content increases, the rate of polishing with the polishing composition is advantageously improved.

The content of the abrasive grains in the polishing composition is preferably 5% by mass or less, more preferably 1% by mass or less, and even more preferably 0.5% by mass or less. A decrease in the abrasive grain content is advantageous in that the material cost of the polishing composition is reduced and additionally, in that dishing becomes unlikely to occur on the surface of an object after polishing with the polishing composition.

Next, a second embodiment of the present invention will now be described.

A polishing composition of the second embodiment mainly differs from the polishing composition of the first embodiment in containing a pH-controlling agent in place of the pH-buffering agent. The polishing composition of the second embodiment will now be described below mainly in regard to this point of difference.

(pH-controlling agent)

The pH-controlling agent is defined as a compound that forms a basic substance in an aqueous solution in the presence of an oxidizing agent. With the polishing composition of the second embodiment, by containing the pH-lowering substance and the pH-controlling agent, the change of pH of the polishing composition with time can be suppressed. The lowering of polishing performance with time of the polishing composition can thus be suppressed to a level that does not present a problem in terms of practical use and a polishing composition of excellent stability can be provided.

The basic substance that is formed in the presence of an oxidizing agent may be any of ammonia, methylamine, dimethylamine, trimethylamine, ethylamine, diethylamine, triethylamine, ethylenediamine, diethylenetriamine, triethylenetetramine, tetraethylenepentamine, iminobispropylamine, dimethylaminoethylamine, dimethylaminopropylamine, and diethylaminoethylamine, and ammonia is especially preferable since it is low in molecular weight and rapid pH control is expected.

The pH-controlling agent is preferably a compound having an amide group and is more preferably an amphoteric amino acid further having at least one of a sulfo group and a carboxyl group in addition to the amide group. The pH-controlling agent may be a compound represented by the following general formula (2).

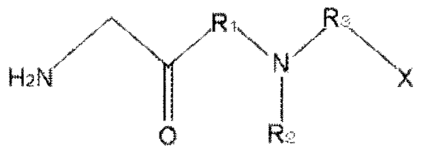

... (2)

In the general formula (2), $R_1$ and $R_3$ each independently represent a non-substituted or substituted straight-chain alkyl group with 1 to 4 carbon atoms. $R_2$ represents a hydrogen atom, a hydroxyl group, a sulfo group, a carboxyl group, a phosphono group, an amino group, an amide group, a carbamoyl group, a nitro group, a methoxy group, an ethoxy group, a halogen group, a phenyl group, an acetyl group, an acyl group, or a non-substituted or substituted alkyl

group with 1 to 4 carbon atoms. X represents a sulfo group, a carboxyl group, or a salt thereof.

Preferable compounds represented by the general formula (2) are N-(2-acetamido)iminodiacetic acid and N-(2-acetamido)-2-aminoethanesulfonic acid, and N-(2-acetamido)-2-aminoethanesulfonic acid is most preferable.

With regard to aqueous solutions containing either of the two compounds described above as examples of the pH-controlling agent or an alternative compound, whether the basic substance is formed or not was examined in the presence of and in the absence of hydrogen peroxide and the results are shown in Table 2. Specifically, each aqueous solution was prepared by mixing a predetermined amount of a pH-controlling agent or an alternative compound with water and thereafter left to stand in storage for eight days under ordinary temperature (23°C to 27°C) using a constant temperature bath. The results of qualitatively and quantitatively analyzing the basic substance in each aqueous solution immediately after preparation and the results of qualitatively and quantitatively analyzing the basic substance in each aqueous solution after being left to stand for eight days are respectively indicated in the "Basic substance concentration immediately after preparation" column and the "Basic substance concentration after eight days" column in the "Without hydrogen peroxide" column of Table 2. Also, 10.32 g of a 31% by weight hydrogen peroxide solution, that is, 3.2 g of hydrogen peroxide were added to 100 ml of each aqueous solution obtained by mixing a predetermined amount of a pH-controlling agent or an alternative compound with water and thereafter each aqueous solution was left to stand in storage for eight days under ordinary temperature (23°C to 27°C) using a constant temperature bath. The results of qualitatively and quantitatively analyzing the basic substance in each aqueous solution immediately after the addition of hydrogen peroxide and the results of qualitatively and quantitatively analyzing the basic substance in each aqueous solution after being left to stand for the eight days are respectively indicated in the "Basic substance concentration immediately after preparation" column and the "Basic substance concentration after eight days" column in the "With hydrogen peroxide" column of Table 2. Qualitative and quantitative analyses of the basic substance in each aqueous solution were performed by an ion chromatography method.

Table 2

| | pH-controlling agent or alternative compound | | With hydrogen peroxide | | Without hydrogen peroxide | |
|---|---|---|---|---|---|---|
| | Name | Content [mM] | Basic substance concentration immediately after preparation [mM] | Basic substance concentration after eight days [mM] | Basic substance concentration immediately after preparation [mM] | Basic substance concentration after eight days [mM] |
| Example 1 (pH-controlling agent) | N-(2-acetamido)-2-aminoethanesulfonic acid | 5.0 | not detected | 1.54 ($NH_4$) | not detected | 0.03 ($NH_4$) |
| Example 2 (pH-controlling agent) | N-(2-acetamido)iminodiacetic acid | 5.0 | not detected | 0.21 ($NH_4$) | not detected | 0.01 ($NH_4$) |
| Example 3 | 3-morpholinopropane sulfonic acid | 5.0 | not detected | 0.02 ($NH_4$) | not detected | 0.01 ($NH_4$) |
| Example 4 | 2-[4-(2-hydroxyethyl)-1-piperazinyl]ethanesulfonic acid | 5.0 | not detected | 0.02 ($NH_4$) | not detected | not detected |
| Example 5 | acetamide | 5.0 | not detected | 0.03 ($NH_4$) | not detected | not detected |
| Example 6 | taurine | 5.0 | not detected | not detected | not detected | not detected |
| Example 7 | phosphoric acid | 5.0 | not detected | not detected | not detected | not detected |

The content of the pH-controlling agent in the polishing composition is preferably no less than 0.01 mM, more preferably no less than 0.1 mM, even more preferably no less than 0.5 mM, yet even more preferably no less than 3.0 mM, and most preferably no less than 5.0 mM. An increase in the pH-controlling agent content is desirable in that the

effect of stabilizing the pH of the polishing composition is improved.

The content of the pH-controlling agent content in the polishing composition is preferably 300 mM or less, more preferably 150 mM or less, even more preferably 100 mM or less, and especially preferably 50 mM or less. A decrease in the pH-controlling agent content is advantageous in that the material cost of the polishing composition is reduced. In particular, when the content is 50 mM or less, a high polishing rate can be maintained in addition to providing the effect of suppressing the change of pH with time of the polishing composition.

The first and second embodiments may be changed as follows.

- The polishing composition according to each of the embodiments may further contain a known additive such as a preservative and a fungicide, as necessary. Examples of preservatives and fungicides include isothiazoline-based preservatives, such as 2-methyl-4-isothiazoline-3-one and 5-chloro-2-methyl-4-isothiazoline-3-one, and paraoxybenzoate esters, and phenoxyethanol.

- The polishing composition according to each of the embodiments may be a one-component composition or may be a multi-component composition as a two-component composition.

- The polishing composition according to each of the embodiments may be prepared by diluting a stock solution of the polishing composition, for example, ten-fold or more with a diluent such as water.

- The polishing composition according to each of the embodiments may be used in applications other than polishing during LSI manufacture.

Next, working examples and comparative examples of the present invention will be described.

(Working Examples 1 to 9 and Comparative Examples 1 to 5)

Polishing compositions of Working Examples 1 to 9 were respectively prepared by mixing an oxidizing agent, a pH-lowering substance, a pH-buffering agent, a polishing accelerator, a surfactant, and abrasive grains in water. Polishing compositions of Comparative Examples 1 to 5 were respectively prepared by mixing an oxidizing agent, a pH-lowering substance, an alternative compound to a pH-buffering agent, a polishing accelerator, a surfactant, and abrasive grains in water. Details of the pH-buffering agent or alternative compound to a pH-buffering agent in the polishing composition of each of Working Examples 1 to 9 and Comparative Examples 1 to 5 are as indicated in the "Name" column and "Content" column in the "pH-buffering agent or alternative compound" column of Table 3. Although not indicated in Table 3, the polishing composition of each of Working Examples 1 to 9 and Comparative Examples 1 to 5 contained 51.6 g/L of a 31 % by weight hydrogen peroxide solution (that is, 16 g/L of hydrogen peroxide) as the oxidizing agent, 0.5 g/L of a polyoxyethylene alkyl ether and 0.15 g/L of a 1:1 mixture of 1-[N,N-bis(hydroxyethyl)aminomethyl]-5-methylbenzotriazole and 1-[N,N-bis(hydroxyethyl)aminomethyl]-4-methylbenzotriazole as the pH-lowering substance, 10 g/L of glycine as the polishing accelerator, 0.3 g/L of ammonium lauryl ether sulfate as the surfactant, and 0.1% by mass of colloidal silica with an average primary particle diameter of 30 nm as determined by the BET method as the abrasive grains. All of the polishing compositions were adjusted to a pH of approximately 7.5 using potassium hydroxide.

Table 3

| | pH-buffering agent or alternative compound | | With hydrogen peroxide | | | Without hydrogen peroxide | | | High-pressure polishing conditions | | | Low-pressure polishing conditions | | |
|---|---|---|---|---|---|---|---|---|---|---|---|---|---|---|
| | Name | Content [mmol/L] | pH immediately after preparation | pH after eight days | pH change amount | pH immediately after preparation | pH after eight days | pH change amount | Polishing rate immediately after preparation [nm/min] | Polishing rate after eight days [nm/min] | Percentage change of polishing rate [%] | Polishing rate immediately after preparation [nm/min] | Polishing rate after eight days [nm/min] | Percentage change of polishing rate [%] |
| Working Example 1 | N-(2-acetamido)-2-aminoethanesulfonic acid | 0.1 | 7.49 | 7.30 | -0.19 | 7.48 | 7.47 | -0.01 | 714 | 734 | 2.8 | 342 | 354 | 3.5 |
| Working Example 2 | N-(2-acetamido)-2-aminoethanesulfonic acid | 0.5 | 7.50 | 7.35 | -0.15 | 7.48 | 7.47 | -0.01 | 713 | 723 | 1.4 | 342 | 348 | 1.8 |
| Working Example 3 | N-(2-acetamido)-2-aminoethanesulfonic acid | 1.0 | 7.49 | 7.40 | -0.09 | 7.47 | 7.47 | 0.00 | 703 | 713 | 1.4 | 332 | 335 | 0.9 |
| Working Example 4 | N-(2-acetamido)-2-aminoethanesulfonic acid | 3.0 | 7.47 | 7.40 | -0.07 | 7.48 | 7.47 | -0.01 | 700 | 703 | 0.4 | 333 | 335 | 0.6 |
| Working Example 5 | N-(2-acetamido)-2-aminoethanesulfonic acid | 5.0 | 7.47 | 7.47 | 0.00 | 7.46 | 7.45 | -0.01 | 696 | 695 | -0.1 | 333 | 334 | 0.3 |
| Working Example 6 | N-(2-acetamido)-2-aminoethanesulfonic acid | 10 | 7.47 | 7.47 | 0.00 | 7.46 | 7.45 | -0.01 | 695 | 696 | 0.1 | 333 | 334 | 0.3 |
| Working Example 7 | N-(2-acetamido)-2-aminoethanesulfonic acid | 25 | 7.47 | 7.47 | 0.00 | 7.46 | 7.45 | -0.01 | 687 | 688 | 0.1 | 341 | 341 | 0.0 |
| Working Example 8 | N-(2-acetamido)-2-aminoethanesulfonic acid | 50 | 7.47 | 7.47 | 0.00 | 7.46 | 7.45 | -0.01 | 515 | 516 | 0.2 | 256 | 256 | 0.0 |
| Working Example 9 | N-(2-acetamido)iminodiacetic acid | 5.0 | 7.41 | 6.95 | -0.46 | 7.45 | 7.43 | -0.02 | 453 | 474 | 4.6 | 189 | 195 | 3.2 |
| Comparative Example 1 | none | 5.0 | 7.55 | 6.49 | -1.06 | 7.44 | 7.41 | -0.03 | 679 | 740 | 9.0 | 320 | 396 | 23.8 |
| Comparative Example 2 | 3-morpholinopropanesulfonic acid | 5.0 | 7.47 | 5.85 | -1.62 | 7.50 | 7.45 | -0.05 | 705 | 804 | 14.0 | 329 | 391 | 18.8 |
| Comparative Example 3 | acetamide | 5.0 | 7.50 | 6.47 | -1.03 | 7.20 | 7.26 | 0.06 | 560 | 725 | 29.5 | 286 | 404 | 41.3 |
| Comparative Example 4 | taurine | 5.0 | 7.55 | 6.53 | -1.02 | 7.19 | 7.17 | -0.02 | 628 | 757 | 20.5 | 329 | 407 | 23.7 |
| Comparative Example 5 | phosphoric acid | 5.0 | 7.50 | 6.88 | -0.62 | 7.50 | 7.47 | -0.03 | 432 | 522 | 20.8 | 256 | 336 | 31.3 |

<pH>

The polishing compositions of Working Examples 1 to 9 and Comparative Examples 1 to 5 were left to stand

in storage for eight days under ordinary temperature (23°C to 27°C) using a constant temperature bath. The pH value of each polishing composition measured immediately after preparation, the pH value of each polishing composition measured after being left to stand for eight days, and the amount of change of pH that occurred within eight days are respectively indicated in the "pH immediately after preparation" column, the "pH after eight days" column, and the "pH change amount" column in the "With hydrogen peroxide" column of Table 3.

Compositions each having a chemical makeup the same as the chemical makeup of one of the polishing compositions of Working Examples 1 to 9 and Comparative Examples 1 to 5 from which hydrogen peroxide is omitted were left to stand in storage for eight days under ordinary temperature (23°C to 27°C) using a constant temperature bath. The pH value of each composition measured immediately after preparation, the pH value of each composition measured after being left to stand for eight days, and the amount of change of pH that occurred within the eight days are respectively indicated in the "pH immediately after preparation" column, the "pH after eight days" column, and the "pH change amount" column in the "without hydrogen peroxide" column of Table 3.

All pH measurements were made under ordinary temperature (23°C to 27°C) using a pH meter (F-52, from Horiba, Ltd.).

<Polishing Rate>

Using the respective polishing compositions of Working Examples 1 to 9 and Comparative Examples 1 to 5 immediately after preparation or after leaving to stand for eight days, the surface of a copper blanket wafer was polished for 60 seconds under the first polishing conditions indicated in Table 4. The polishing rate obtained with each polishing composition immediately after preparation, the polishing rate obtained with each polishing composition after leaving to stand for eight days, and the percentage change of the polishing rate that occurred by eight days of leaving to stand are respectively indicated in the "Polishing rate immediately after preparation" column, the "Polishing rate after eight days" column, and the "Percentage change of polishing rate" column in the "High-pressure polishing conditions" column of Table 3.

Using the respective polishing compositions of Working Examples 1 to 9 and Comparative Examples 1 to 5 immediately after preparation or after leaving to stand for eight days, the surface of a copper blanket wafer was polished for 60 seconds under the second polishing conditions indicated in Table 5. The polishing rate obtained with each polishing composition immediately after preparation, the polishing rate obtained with each polishing composition after leaving to stand for eight days, and the percentage change of the polishing rate that occurred by eight days of leaving to stand are respectively indicated in the "Polishing rate immediately after preparation" column, the "Polishing rate after eight days" column, and the "Percentage change of polishing rate" column in the "Low-pressure polishing conditions" column of Table 3.

All polishing rate values were determined by dividing the difference in thickness of the copper blanket wafer before and after polishing as measured using the sheet resistance meter VR-120/08SD (from Hitachi Kokusai Electric Inc.) by the polishing time. The values of the percentage change of polishing rate were determined according to the following formula.

Percentage change of polishing rate (%) = (Polishing rate after eight days - Polishing rate immediately after preparation) / Polishing rate immediately after preparation $\times$ 100

Table 4

| |
|---|
| <First Polishing Conditions> |
| Polishing machine: Single-side CMP polishing machine (Reflexion LK, from Applied Materials, Inc.) |
| Polishing pad: Polyurethane foam pad |
| Polishing pressure: 2.7 psi (= approx. 18.6 kPa) |
| Rotational speed of surface plate: 90 rpm |
| Feed rate of polishing composition: 300 mL/min |
| Rotational speed of carrier: 90 rpm |

Table 5

| |
|---|
| <Second Polishing Conditions> |
| Polishing machine: Single-side CMP polishing machine (Reflexion LK, from Applied Materials, Inc.) |
| Polishing pad: Polyurethane foam pad |
| Polishing pressure: 1.5 psi (= approx. 10.3 kPa) |

(continued)

| |
|---|
| <Second Polishing Conditions> |
| Rotational speed of surface plate: 90 rpm |
| Feed rate of polishing composition: 300 mL/min |
| Rotational speed of carrier: 90 rpm |

As shown in the "With hydrogen peroxide" column of Table 3, with each of the polishing compositions of Comparative Examples 1 to 5, the amount of pH change upon leaving to stand for eight days exceeded 0.5 in absolute value. On the other hand, with each of the polishing compositions of Working Examples 1 to 9, the amount of pH change upon leaving to stand for eight days was 0.5 or less in absolute value. As shown in the "High-pressure polishing conditions" column and the "Low-pressure polishing conditions" column of Table 3, the percentage change of polishing rate of each of the polishing compositions of Working Examples 1 to 9 was ±5% or less and satisfactory. These results suggest that the polishing performance of a polishing composition is stabilized by preventing the change with time of the pH of the polishing composition.

A comparison of the results of Working Example 5 and Working Example 9 revealed that the amount of pH change and the percentage change of polishing rate are smaller when N-(2-acetamido)-2-aminoethanesulfonic acid is used than when N-(2-acetamido)-iminodiacetic acid is used. Further, a comparison of the results of Working Examples 1 to 7 revealed that by using N-(2-acetamido)-2-aminoethanesulfonic acid at a content of no less than 0.5 mmol/L, the percentage change of polishing rate is suppressed to ±2% or less and the polishing performance is extremely stable.

(Working Examples 11 to 21 and Comparative Examples 11 to 17)

Polishing compositions of Working Examples 11 to 21 were respectively prepared by mixing an oxidizing agent, a pH-lowering substance, a pH-controlling agent, a polishing accelerator, a surfactant, and abrasive grains in water. Polishing compositions of Comparative Examples 11 to 17 were respectively prepared by mixing an oxidizing agent, a pH-lowering substance, an alternative compound to a pH-controlling agent, a polishing accelerator, a surfactant, and abrasive grains in water. Details of the pH-controlling agent or the alternative compound to a pH-controlling agent in the polishing composition of each of Working Examples 11 to 21 and Comparative Examples 11 to 17 are as indicated in the "Name" columns and "Content" columns in the "pH-controlling agent or alternative compound" columns of Tables 6 and 7. Although not indicated in Tables 6 and 7, the polishing composition of each of Working Examples 11 to 21 and Comparative Examples 11 to 17 contained 51.6 g/L of a 31 % by weight hydrogen peroxide solution (that is, 16 g/L of hydrogen peroxide) as the oxidizing agent, 0.5 g/L of a polyoxyethylene alkyl ether and 0.15 g/L of a 1:1 mixture of 1-[N,N-bis(hydroxyethyl)aminomethyl]-5-methylbenzotriazole and 1-[N,N-bis(hydroxyethyl)aminomethyl]-4-methylbenzotriazole as the pH-lowering substance, 10 g/L of glycine as the polishing accelerator, 0.3 g/L of ammonium lauryl ether sulfate as the surfactant, and 0.1% by mass of colloidal silica with an average primary particle diameter of 30 nm as determined by the BET method as the abrasive grains. All of the polishing compositions were adjusted to a pH of approximately 7.5 using potassium hydroxide.

Table 6

| | pH-controlling agent or alternative compound | | With hydrogen peroxide | | | Without hydrogen peroxide | | | High-pressure polishing conditions | | | Low-pressure polishing conditions | | | Amount of increase in basic substance concentration [mM] |
|---|---|---|---|---|---|---|---|---|---|---|---|---|---|---|---|
| | Name | Content [mM] | pH immediately after preparation | pH after eight days | pH change amount | pH immediately after preparation | pH after eight days | pH change amount | Polishing rate immediately after preparation [nm/min] | Polishing rate after eight days [nm/min] | Percentage change of polishing rate [%] | Polishing rate immediately after preparation [nm/min] | Polishing rate after eight days [nm/min] | Percentage change of polishing rate [%] | |
| Working Example 11 | N-(2-acetamido)-2-aminoethanesulfonic acid | 0.5 | 7.50 | 7.25 | -0.25 | 7.48 | 7.47 | -0.01 | 713 | 743 | 4.0 | 342 | 358 | 4.5 | 0.16 ($NH_4$) |
| Working Example 12 | N-(2-acetamido)-2-aminoethanesulfonic acid | 1.0 | 7.49 | 7.38 | -0.11 | 7.47 | 7.47 | 0.00 | 703 | 713 | 1.4 | 332 | 335 | 0.9 | 0.31 ($NH_4$) |
| Working Example 13 | N-(2-acetamido)-2-aminoethanesulfonic acid | 3.0 | 7.47 | 7.40 | -0.07 | 7.48 | 7.47 | -0.01 | 700 | 703 | 0.4 | 333 | 335 | 0.6 | 0.90 ($NH_4$) |
| Working Example 14 | N-(2-acetamido)-2-aminoethanesulfonic acid | 5.0 | 7.47 | 7.46 | 0.01 | 7.46 | 7.45 | -0.01 | 696 | 695 | -0.1 | 334 | 336 | 0.6 | 1.53 ($NH_4$) |
| Working Example 15 | N-(2-acetamido)-2-aminoethanesulfonic acid | 10 | 7.47 | 7.47 | 0.00 | 7.46 | 7.45 | -0.01 | 695 | 696 | 0.1 | 333 | 334 | 0.3 | 2.54 ($NH_4$) |
| Working Example 16 | N-(2-acetamido)-2-aminoethanesulfonic acid | 25 | 7.47 | 7.47 | 0.00 | 7.46 | 7.45 | -0.01 | 687 | 688 | 0.1 | 341 | 341 | 0.0 | 3.54 ($NH_4$) |
| Working Example 17 | N-(2-acetamido)-2-aminoethanesulfonic acid | 50 | 7.48 | 7.47 | 0.01 | 7.46 | 7.45 | -0.01 | 515 | 516 | 0.2 | 256 | 256 | 0.0 | 4.54 ($NH_4$) |
| Working Example 18 | N-(2-acetamido) iminodiacetic acid | 5.0 | 7.41 | 6.95 | -0.46 | 7.45 | 7.43 | -0.02 | 453 | 474 | 4.4 | 189 | 195 | 3.1 | 0.21 ($NH_4$) |
| Working Example 19 | N-(2-acetamido) iminodiacetic acid | 10 | 7.48 | 7.47 | -0.01 | 7.49 | 7.48 | -0.01 | 453 | 454 | 0.2 | 189 | 190 | 0.5 | 0.43 ($NH_4$) |
| Working Example 20 | N-(2-acetamido) iminodiacetic acid | 25 | 7.50 | 7.50 | 0.00 | 7.47 | 7.48 | 0.01 | 453 | 455 | 0.4 | 189 | 190 | 0.5 | 1.07 ($NH_4$) |
| Working Example 21 | N-(2-acetamido) iminodiacetic acid | 50 | 7.49 | 7.48 | -0.01 | 7.48 | 7.46 | -0.02 | 453 | 452 | -0.2 | 189 | 189 | 0.0 | 1.99 ($NH_4$) |

Table 7

| | pH-controlling agent or alternative compound | | With hydrogen peroxide | | | Without hydrogen peroxide | | | High-pressure polishing conditions | | | Low-pressure polishing conditions | | | Amount of increase in basic substance concentration [mM] |
|---|---|---|---|---|---|---|---|---|---|---|---|---|---|---|---|
| | Name | Content [mM] | pH immediately after preparation | pH after eight days | pH change amount | pH immediately after preparation | pH after eight days | pH change amount | Polishing rate immediately after preparation [nm/min] | Polishing rate after eight days [nm/min] | Percentage change of polishing rate [%] | Polishing rate immediately after preparation [nm/min] | Polishing rate after eight days [nm/min] | Percentage change of polishing rate [%] | |
| Comparative Example 11 | none | - | 7.55 | 6.49 | -1.06 | 7.44 | 7.41 | -0.03 | 679 | 740 | 8.2 | 320 | 396 | 19.2 | not detected |
| Comparative Example 12 | N-(2-acetamido)-2-aminoethanesulfonic acid | 0.5 | 7.50 | 6.49 | -1.01 | 7.44 | 7.41 | -0.03 | 453 | 482 | 6.0 | 189 | 206 | 8.3 | 0.02 ($NH_4$) |
| Comparative Example 13 | 3-morpholinopropanesulfonic acid | 5.0 | 7.47 | 5.85 | -1.62 | 7.50 | 7.45 | -0.05 | 705 | 804 | 12.3 | 329 | 391 | 15.9 | 0.02 ($NH_4$) |
| Comparative Example 14 | 2-[4-(2-hydroxyethyl)-1-piperazinyl]ethanesulfonic acid | 5.0 | 7.50 | 6.74 | -0.76 | 7.50 | 7.45 | -0.05 | 702 | 808 | 13.1 | 326 | 387 | 15.8 | 0.02 ($NH_4$) |
| Comparative Example 15 | acetamide | 5.0 | 7.50 | 6.47 | -1.03 | 7.20 | 7.26 | 0.06 | 560 | 725 | 22.8 | 286 | 404 | 29.2 | 0.03 ($NH_4$) |
| Comparative Example 16 | taurine | 5.0 | 7.55 | 6.53 | -1.02 | 7.19 | 7.17 | -0.02 | 628 | 757 | 17.0 | 329 | 407 | 19.2 | not detected |
| Comparative Example 17 | phosphoric acid | 5.0 | 7.50 | 6.88 | -0.62 | 7.50 | 7.47 | -0.03 | 432 | 522 | 17.2 | 256 | 336 | 23.8 | not detected |

<pH>

The polishing compositions of Working Examples 11 to 21 and Comparative Examples 11 to 17 were left to stand in storage for eight days under ordinary temperature (23°C to 27°C) using a constant temperature bath. The pH value of each polishing composition measured immediately after preparation, the pH value of each polishing composition measured after being left to stand for eight days, and the amount of change of pH that occurred within eight days are respectively indicated in the "pH immediately after preparation" columns, the "pH after eight days" columns, and the "pH change amount" columns in the "With hydrogen peroxide" columns of Tables 6 and 7.

Compositions each having a chemical makeup the same as the chemical makeup of one of the polishing compositions of Working Examples 11 to 21 and Comparative Examples 11 to 17 from which hydrogen peroxide is omitted were left to stand in storage for eight days under ordinary temperature (23°C to 27°C) using a constant temperature bath. The pH value of each composition measured immediately after preparation, the pH value of each composition measured after being left to stand for eight days, and the amount of change of pH that occurred within the eight days are respectively indicated in the "pH immediately after preparation" columns, the "pH after eight days" columns, and the "pH change amount" columns in the "Without hydrogen peroxide" columns of Tables 6 and 7.

All pH measurements were made under ordinary temperature (23°C to 27°C) using a pH meter (F-52, from Horiba, Ltd.).

<Polishing Rate>

Using the respective polishing compositions of Working Examples 11 to 21 and Comparative Examples 11 to 17 immediately after preparation or after leaving to stand for eight days, the surface of a copper blanket wafer was polished under the third polishing conditions indicated in Table 8. The polishing rate obtained with each polishing composition immediately after preparation, the polishing rate obtained with each polishing composition after leaving to stand for eight days, and the percentage change of the polishing rate that occurred by eight days of leaving to stand are respectively indicated in the "Polishing rate immediately after preparation" columns, the "Polishing rate after eight days" columns, and the "Percentage change of polishing rate" columns in the "High-pressure polishing conditions" columns of Tables 6 and 7.

Using the respective polishing compositions of Working Examples 11 to 21 and Comparative Examples 11 to 17 immediately after preparation or after leaving to stand for eight days, the surface of a copper blanket wafer was polished under the fourth polishing conditions indicated in Table 9. The polishing rate obtained with each polishing composition immediately after preparation, the polishing rate obtained with each polishing composition after leaving to stand for eight days, and the percentage change of the polishing rate that occurred by eight days of leaving to stand are respectively indicated in the "Polishing rate immediately after preparation" columns, the "Polishing rate after eight days" columns, and the "Percentage change of polishing rate" columns in the "Low-pressure polishing conditions" columns of Tables 6 and 7.

All polishing rate values were determined by dividing the difference in thickness of the copper blanket wafer before and after polishing as determined by measurement of the sheet resistance using the DC four-probe method by the polishing time. The values of the percentage change of polishing rate were determined according to the following formula.

Percentage change of polishing rate (%) = (Polishing rate after eight days − Polishing rate immediately after preparation) / Polishing rate immediately after preparation × 100

Table 8

| |
|---|
| <Third Polishing Conditions> |
| Polishing machine: Single-side CMP polishing machine |
| Polishing pad: Polyurethane foam pad |
| Polishing pressure: 2.7 psi (= approx. 18.6 kPa) |
| Rotational speed of surface plate: 90 rpm |
| Feeding of polishing composition: Continuously fed without being circulated |
| Rotational speed of carrier: 90 rpm |

Table 9

| |
|---|
| <Fourth Polishing Conditions> |
| Polishing machine: Single-side CMP polishing machine |
| Polishing pad: Shooting polyurethane pad |
| Polishing pressure: 1.2 psi (= approx. 8.3 kPa) |
| Rotational speed of surface plate: 90 rpm |
| Feeding of polishing composition: Continuously fed without being circulated |
| Rotation speed of carrier: 90 rpm |

<Amount of Increase in Basic Substance>

With each of the polishing compositions of Working Examples 11 to 21 and Comparative Examples 11 to 17, the concentration of basic substance in the polishing composition immediately after preparation and the concentration of basic substance in the polishing composition after leaving to stand for eight days were measured. The concentration differences are indicated in the "Amount of increase in basic substance concentration" columns of Tables 6 and 7. Qualitative and quantitative analyses of the basic substance in the respective polishing compositions were performed by the ion chromatography analysis method.

As shown in the "With hydrogen peroxide" column of Table 7, with each of the polishing compositions of Comparative Examples 11 to 17, the amount of pH change upon leaving to stand for eight days exceeded 0.5 in absolute value. On the other hand, as shown in the "With hydrogen peroxide" column of Table 6, with each of the polishing compositions of Working Examples 11 to 21, the amount of pH change upon leaving to stand for eight days was 0.5 or less in absolute value. As shown in the "High-pressure polishing conditions" column and the "Low-pressure polishing

conditions" column of Table 6, the percentage change of polishing rate of each of the polishing compositions of Working Examples 11 to 21 was ±5% or less and satisfactory. These results suggest that the polishing performance of a polishing composition is stabilized by preventing the change with time of the pH of the polishing composition.

A comparison of the results of Working Examples 19 to 21 and Comparative Example 12 revealed a trend such that the greater the amount of an increase in concentration of the basic substance, the less the amount of pH change and percentage change of polishing rate.

A comparison of the results of Working Example 14 to 17 and Working Examples 18 to 21 revealed that the amount of pH change and the percentage change of polishing rate are smaller when N-(2-acetamido)-2-aminoethanesulfonic acid is used than when N-(2-acetamido)-iminodiacetic acid is used.

## Claims

**1.** A polishing composition comprising:

a substance that lowers the pH of an aqueous solution in the presence of an oxidizing agent; and
a pH-buffering agent,
wherein the difference in absolute value between the pH of the polishing composition immediately after adding a 31% by weight hydrogen peroxide solution thereto at 5.16 g per 100 g of the polishing composition and the pH of the polishing composition after leaving to stand for eight days from the addition of the hydrogen peroxide solution is 0.5 or less.

**2.** The polishing composition according to claim 1, wherein the pH-buffering agent is a compound having an amide group.

**3.** The polishing composition according to claim 1 or 2, wherein the pH-buffering agent is an amphoteric amino acid having at least one of a sulfo group and a carboxyl group.

**4.** The polishing composition according to any one of claims 1 to 3, wherein the pH-buffering agent is a compound represented by the following general formula (1), in which $R_1$ and $R_3$ each independently represent a non-substituted or substituted straight-chain alkyl group with 1 to 4 carbon atoms, $R_2$ represents a hydrogen atom, a hydroxyl group, a sulfo group, a carboxyl group, an amino group, an amide group, a carbamoyl group, a nitro group, a methoxy group, an ethoxy group, a halogen group, a phenyl group, an acetyl group, or a non-substituted or substituted alkyl group with 1 to 4 carbon atoms, and X represents a sulfo group, a carboxyl group, or a salt thereof.

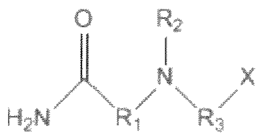
... (1)

**5.** The polishing composition according to claim 4, wherein in the general formula (1), X is a sulfo group or a salt thereof.

**6.** A polishing composition comprising:

a substance that lowers the pH of an aqueous solution in the presence of an oxidizing agent; and
a pH-controlling agent,
wherein in comparison to the amount of a basic substance in the polishing composition immediately after adding a 31% by weight hydrogen peroxide solution thereto at 5.16 g per 100 ml of the polishing composition, the amount of a basic substance in the polishing composition after leaving to stand for eight days from the addition of the hydrogen peroxide solution is increased by no less than 0.1 mM.

**7.** The polishing composition according to claim 6, wherein the difference in absolute value between the pH of the polishing composition immediately after adding a 31% by weight hydrogen peroxide solution thereto at 5.16 g per 100 ml of the polishing composition and the pH of the polishing composition after leaving to stand for eight days from the addition of the hydrogen peroxide solution is 0.5 or less.

**8.** The polishing composition according to claim 6 or 7, wherein the basic compound is ammonia.

**9.** The polishing composition according to any one of claims 6 to 8, wherein in comparison to the amount of a basic substance in a 100 ml of aqueous solution containing 5.0 mM of the pH-controlling agent immediately after adding 10.32 g of a 31 % by weight hydrogen peroxide solution thereto, the amount of a basic substance in the aqueous solution after leaving to stand for eight days from the addition of the hydrogen peroxide solution is increased by no less than 0.2 mM.

**10.** The polishing composition according to any one of claims 6 to 9, wherein the pH-controlling agent is a compound having an amide group.

**11.** The polishing composition according to any one of claim 6 to 10, wherein the pH-controlling agent is an amphoteric amino acid having at least one of a sulfo group and a carboxyl group.

**12.** The polishing composition according to any one of claims 6 to 11, wherein the pH-controlling agent is a compound represented by the following general formula (2), in which $R_1$ and $R_3$ each independently represent a non-substituted or substituted straight-chain alkyl group with 1 to 4 carbon atoms, $R_2$ represents a hydrogen atom, a hydroxyl group, a sulfo group, a phosphono group, a carboxyl group, an amino group, an amide group, a carbamoyl group, a nitro group, a methoxy group, an ethoxy group, a halogen group, a phenyl group, an acetyl group, an acyl group, or a non-substituted or substituted alkyl group with 1 to 4 carbon atoms, and X represents a sulfo group, a carboxyl group, or a salt thereof.

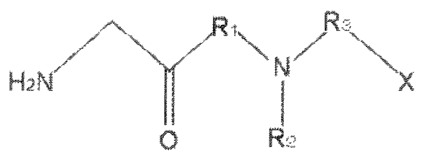

... (2)

**13.** The polishing composition according to claim 12 wherein in the general formula (2), X is a sulfo group or a salt thereof.

**14.** A method of polishing a metal with the polishing composition according to any one of claims 1 to 13.

**15.** The polishing method according to claim 14, wherein an oxidizing agent is mixed in the polishing composition when polishing.

**16.** A method of producing a metal-containing substrate, comprising polishing a metal by the method according to claim 14 or 15.

**INTERNATIONAL SEARCH REPORT**

International application No.
PCT/JP2012/058195

A. CLASSIFICATION OF SUBJECT MATTER
*H01L21/304*(2006.01)i, *B24B37/00*(2012.01)i, *C09K3/14*(2006.01)i

According to International Patent Classification (IPC) or to both national classification and IPC

B. FIELDS SEARCHED

Minimum documentation searched (classification system followed by classification symbols)
H01L21/304, B24B37/00, C09K3/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2008-085145 A (Fujifilm Corp.), 10 April 2008 (10.04.2008), paragraphs [0011] to [0015], [0028], [0032] to [0050], [0070] to [0071], [0082] to [0085] (Family: none) | 1-5,14-16<br>6-13 |

☐ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 May, 2012 (09.05.12) | 22 May, 2012 (22.05.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 62102543 A
- JP 8083780 A
- JP 2000501771 A
- JP 2006506809 A